# FASCICULE DE BREVET EUROPEEN

(11) **EP 3 089 555 B1**
(45) Date de publication et mention de la délivrance du brevet: **27.05.2020**
(21) Numéro de dépôt: 16167490.8
(22) Date de dépôt: 28.04.2016
(51) Int. Cl.: H05B 33/08, H05B 37/03

(54) **DISPOSITIF ET PROCÉDÉ DE DÉTECTION D'UNE DIODE ÉLECTROLUMINESCENTE COURT-CIRCUITÉE DANS UN DISPOSITIF LUMINEUX D'UN VÉHICULE AUTOMOBILE**
VORRICHTUNG UND VERFAHREN ZUR ERFASSUNG EINER KURZGESCHLOSSENEN ELEKTROLUMINESZENZDIODE IN EINER LEUCHTVORRICHTUNG EINES KRAFTFAHRZEUGS
DEVICE AND METHOD FOR DETECTING A SHORT-CIRCUITED LIGHT-EMITTING DIODE IN A MOTOR VEHICLE LIGHTING DEVICE

(30) Priorité: 29.04.2015 FR 1553888
(43) Date de publication de la demande: 02.11.2016
(73) Titulaire: VALEO VISION, 93012 Bobigny Cedex (FR)
(72) Inventeur: LESAFFRE, Olivier-Sébastien, 93500 PANTIN (FR)

(56) Documents cités:
- US-A1- 2007 159 118
- US-A1- 2012 098 430

## Description

L'invention a trait au domaine des dispositifs lumineux pour véhicules automobiles, notamment des dispositifs lumineux qui utilisent une pluralité de diodes électroluminescentes, LED, pour réaliser au moins une fonction lumineuse d'un véhicule automobile.

Une diode électroluminescente, LED, est un composant électronique semi-conducteur qui émet de la lumière lorsque qu'il est parcouru par un courant électrique d'une intensité spécifique. Une propriété qui caractérise une LED est sa tension directe V_{f}. C'est la chute de tension mesurée aux bornes de la LED lorsque celle-ci est parcourue par un courant électrique et émet de la lumière. Le développement de composants semi-conducteurs de plus en plus performants entraine la parution des LEDs ayant des tensions directes de plus en plus basses. La tension directe d'une LED est, à courant égal, une fonction décroissante de sa température de jonction semi-conductrice.

Dans l'industrie automobile, et en particulier dans le domaine des dispositifs lumineux pour véhicules automobiles, l'utilisation de LEDs est de plus en plus préconisée pour remplacer des sources lumineuses à incandescence traditionnellement utilisées. En effet, la faible consommation électrique des LEDs présente un atout indéniable. En plus, une pluralité de LEDs peut être placée sur un contour prédéterminé, permettant ainsi la création de signatures optiques intéressantes et individuelles des feux d'un véhicule automobile. Il est connu d'utiliser une pluralité de LEDs branchées en série pour réaliser une fonction lumineuse d'un véhicule automobile comme par exemple la fonction feux diurnes, indicateur de direction ou feux de route. Lorsque la jonction d'une des LEDs d'un tel montage en série défectueuse, on parle d'un court-circuit de la LED en question. Les projecteurs d'un véhicule automobile peuvent être sujets à des conditions météorologiques très variées. Ainsi des LEDs faisant partie d'un tel projecteur doivent pouvoir fonctionner à des températures très basses de l'ordre de -20°C ou moins, ainsi qu'à des températures de fonctionnement du dispositif, pouvant dépasser les 80°C.

Il est connu de détecter une LED court-circuitée en comparant la tension aux bornes du montage en série à une tension directe cumulée. Une telle solution connue part du principe que si la tension mesurée est inférieure à N·V_{f}, N étant le nombre de LEDs branchées en série et V_{f} étant leur tension directe, alors une des LEDs est court-circuitée. Avec un nombre de LEDs croissant monté en série, ce procédé peut cependant dans de nombreuses occurrences produire de fausses détections positives. Par exemple, sur une plage de température allant de -40°C à 90°C, la tension directe V_{f} d'une LED peut présenter des variations d'environ 0,6V. La tension directe minimale V_{fmin}, à température maximale, de la même LED peut être égale à environ 2,3V. Dans une telle configuration, la tension aux bornes d'un montage en série comprenant N LEDs peut présenter des variations de N·0,6 V dues exclusivement à la température de jonction des LEDs. Clairement, à partir de N=6, l'amplitude de ces variations excède largement la tension directe minimale de chacune des LEDs du montage. Par conséquent un court-circuit d'une LED ne peut plus être détecté de manière certaine et le procédé connu est susceptible de produire des fausses alertes.

Le document de brevet DE 10 2007 024 784 B4 décrit un dispositif capable de détecter le court-circuit d'une LED dans un montage en série. Lorsqu'une défaillance est détectée, un signal d'alerte est notifié à l'utilisateur du véhicule par le biais du système d'information interne du véhicule. La solution décrite n'est pas capable de prendre en considération les variations de tension directes liées à la température de jonction des LEDs.

Le document de brevet US 7,638,947 B2 présente un dispositif destiné à détecter un court-circuit d'une LED dans un montage en série. Selon un mode de réalisation décrit, le dispositif peut être adapté pour prendre en considération une variation de la tension directe en fonction de la température des LEDs du montage en série. Néanmoins, la solution proposée requiert la présence de composants électroniques dédiés sur le circuit imprimé qui supporte les LEDs. Les composants dédiée doivent être agencés de manière spécifique aux bornes d'au moins une des LEDs, ce qui engendre un coût de production accru, une contrainte supplémentaire lors de la conception d'un tel circuit imprimé, ainsi qu'une perte d'espace potentielle sur le circuit imprimé.

Le document de brevet US 2012/098430 A1 décrit un dispositif lumineux configuré pour détecter un court circuit d'une LED, dans lequel le dispositif est adapté à calculer et enregistrer des valeurs de tensions moyennes calculées pendant des périodes définies et à des températures de jonction de LEDs mesurées, dans lequel les valeurs de tensions moyennes calculées sont ramenées à une température de référence de 25°C en utilisant une valeur de correction de la tension en fonction de la température mesurée.

Le document de brevet US 2007/159118 A1 décrit un dispositif lumineux pour un véhicule automobile, dans lequel une défaillance des LEDs est détectée au moyen de la mesure de la tension aux bornes des sections de LEDs en série et de la mesure de la température ambiante.

L'invention a pour objectif de pallier à au moins un des problèmes posés par l'art antérieur. Plus précisément, l'invention a pour objectif de proposer un dispositif et un procédé capables de détecter le court-circuit d'une LED dans un montage en série indépendamment des variations de températures de jonction et utilisant des composants déjà largement existants dans des dispositifs lumineux pour véhicules automobiles connus.

L'invention a pour objet un dispositif lumineux pour un véhicule automobile. Le dispositif comprend des moyens de pilotage de l'alimentation d'une pluralité de diodes électroluminescentes, LED, montées en série. Chacune des LEDs se caractérise par la même tension directe V_{f} dépendante de sa température de jonction. Le dispositif comprend des premiers moyens de mesure aptes de la température de jonction des LEDs et des deuxièmes moyens de mesure de la tension électrique aux bornes du montage. Le dispositif comprend également des moyens de traitement pour détecter une défaillance d'au moins une des LEDs du montage. Le dispositif est remarquable en ce que les moyens de traitement sont configurés à
- comparer la tension électrique aux bornes du montage mesurée à un premier instant donné à la tension électrique aux bornes du montage mesurée à un deuxième instant donné, la comparaison étant conditionnée à l'identité de la température de jonction des LEDs mesurée audits premier et deuxième instants ; et
- détecter une défaillance d'au moins une des LEDs du montage en fonction de cette comparaison.

Par exemple, ladite comparaison de tension électrique peut être réalisée en comparant directement les deux tensions, ou l'une de ces tensions à une tension de comparaison immédiatement dépendante de l'autre tension. Par exemple, la tension de comparaison peut être égale à l'autre tension moins une tension de tolérance.

De manière équivalente ou cumulative, la comparaison peut être conditionnée à l'identité des courants traversant les LEDs, les courants étant mesurés audits premier et deuxième instants.

Le dispositif comprend un élément de mémoire, les moyens de traitement étant configurés pour lire et écrire dans ledit élément de mémoire. Les moyens de traitement sont en outre configurés pour:
- obtenir à l'aide des moyens de mesure une mesure Tₘₑₛ indicative de la température de jonction d'au moins une des LEDs et une mesure Vₘₑₛ indicative de la tension électrique aux bornes du montage à un instant donné lorsque le montage est alimenté.
- si l'élément de mémoire comprend une valeur de tension V_{cal} associée à la température Tₘₑₛ, comparer la mesure Vₘₑₛ à V_{cal} ou à une tension de comparaison dépendant directement de V_{cal} ;
- conclure qu'une des LEDs du montage est court-circuitée en fonction de ladite comparaison.

Le cas échéant, la température mesurée Tₘₑₛ doit être sensiblement identique à la température stockée dans l'élément de mémoire.

De préférence, les moyens de traitement peuvent être configurés pour :
- si l'élément de mémoire comprend une valeur de tension V_{cal} associée à la température Tₘₑₛ, comparer la mesure Vₘₑₛ à (V_{cal}+/-α), 0 < α ≤V_{f} ;
- conclure qu'une des LEDs du montage est court-circuitée en fonction si Vₘₑₛ<(V_{cal}+/-α).

De préférence, les moyens de traitement peuvent être configurés de manière à mettre à jour la valeur de tension V_{cal} enregistrée en utilisant la valeur Vₘₑₛ, si Vₘₑₛ ≥ (V_{cal}+/-α) ;

Les moyens de traitement sont configurés pour :
- si l'élément de mémoire ne comprend pas de valeur de tension associée à la mesure Tₘₑₛ, enregistrer la mesure Vₘₑₛ et l'associer à la mesure Tₘₑₛ dans l'élément de mémoire.

Les premiers moyens de mesure peuvent de préférence comprendre un thermistor arrangé en proximité du montage comprenant la pluralité de LEDs.

Les moyens de traitement peuvent préférentiellement comprendre un élément microcontrôleur.

De préférence, l'élément de mémoire peut être intégré à l'élément microcontrôleur.

L'élément microcontrôleur peut de préférence faire partie des moyens de pilotage de l'alimentation des LEDs.

De manière préférée, le montage et les premiers moyens de mesure sont disposés sur un même substrat. Il peut par exemple s'agir du substrat d'un circuit imprimé, PCB, ou d'un dispositif d'interconnexion moulé, MID.

L'invention a également pour objet un procédé de détection d'une diode électroluminescente, LED, court-circuitée dans un dispositif lumineux pour un véhicule automobile. Le dispositif comprend des moyens de pilotage de l'alimentation d'une pluralité de diodes électroluminescentes, LED, montées en série. Chacune des LEDs se caractérise par la même tension directe V_{f} dépendante de sa température de jonction. Le dispositif comprend également des premiers moyens de mesure de la température de jonction des LEDs et des deuxièmes moyens de de la tension électrique aux bornes du montage. Le dispositif comprend des moyens de traitement pour détecter une défaillance d'au moins une des LEDs du montage. Le procédé est remarquable en ce qu'il comprend les étapes suivantes :
- comparer la tension électrique aux bornes du montage mesurée à un premier instant donné à la tension électrique aux bornes du montage mesurée à un deuxième instant donné, la comparaison étant conditionnée à l'identité de la température de jonction des LEDs mesurée audits premier et deuxième instants ; et
- détecter une défaillance d'au moins une des LEDs du montage en fonction de cette comparaison.

Le procédé comprend les étapes suivantes :
- obtenir à l'aide des moyens de mesure une mesure Tₘₑₛ indicative de la température de jonction d'au moins une des LEDs et une mesure Vₘₑₛ indicative de la tension électrique aux bornes du montage à un instant donné lorsque le montage est alimenté.

Le procédé comprend les étapes suivantes :
- si l'élément de mémoire comprend une valeur de tension V_{cal} associée à la température Tₘₑₛ, comparer la mesure Vₘₑₛ à V_{cal} ou à une tension de comparaison dépendant directement de V_{cal};
- conclure qu'une des LEDs du montage est court-circuitée en fonction de ladite comparaison.

De préférence, le procédé peut comprendre les étapes suivantes :
- si l'élément de mémoire comprend une valeur de tension V_{cal} associée à la température Tₘₑₛ, comparer la mesure Vₘₑₛ à (V_{cal}+/-α), 0 < α ≤Vf ;
- conclure qu'une des LEDs du montage est court-circuitée si Vₘₑₛ<(V_{cal}+/-α).

Le procédé comprend les étapes suivantes :
- si l'élément de mémoire ne comprend pas de valeur de tension associée à la mesure Tₘₑₛ, enregistrer la mesure Vₘₑₛ et l'associer à la mesure Tₘₑₛ dans l'élément de mémoire.

Le procédé peut de manière préférée comprendre en outre une étape de mise à jour de la valeur de tension V_{cal} enregistrée et associée à la mesure Tₘₑₛ en utilisant la valeur Vₘₑₛ, si Vₘₑₛ ≥ (V_{cal}+/-α).

Le procédé peut de préférence comprendre une étape intermédiaire de filtrage des mesures suite à l'étape d'obtention des mesures. Lors de cette étape, des mesures n'appartenant pas à une plage prédéterminée sont écartées. La plage de mesure prédéterminée pour la mesure Tₘₑₛ peut de préférence comprendre les valeurs entre -40°C et 90°C.

De manière préférée, la plage de mesures prédéterminée pour la mesure Vₘₑₛ peut comprendre les valeurs entre 0 Volt et N·V_{fmax} Volt, N étant le nombre de LEDs du montage et V_{fmax} étant la tension directe d'une des LEDs du montage à -40°C.

Les étapes du procédé sont répétées de manière périodique. La période de répétition peut par exemple avoir une durée comprise entre 2 secondes et 10 minutes, de préférence entre 2 et 30 secondes.

Les étapes du procédé peuvent de préférence être mises en oeuvre si la température de jonction des LEDs et la tension électrique aux bornes du montage ont des valeurs généralement constantes.

Lors l'étape de mise à jour, la valeur de tension associée V_{cal} à la mesure Tₘₑₛ peut préférentiellement être remplacée par une moyenne pondérée de la valeur de tension associée et de la valeur de tension mesurée Vₘₑₛ.

Lors de l'étape d'enregistrement, la valeur de tension mesurée Vₘₑₛ peut de préférence être remplacée par une moyenne pondérée de la valeur Vₘₑₛ et d'au moins une valeur de tension associée dans l'élément de mémoire à une température comprise dans la plage [Tₘₑₛ-β, Tₘₑₛ+β], β étant compris entre 0,1 et 30 °C.

De préférence le procédé peut également comprendre une étape préalable de mise à disposition de valeurs de tension initiales associées à une pluralité de valeurs de températures dans l'élément de mémoire.

Avantageusement, le procédé est mis en oeuvre par un dispositif lumineux selon l'invention.

En utilisant les mesures selon l'invention, il devient possible de détecter le court-circuit d'une LED dans un montage en série d'une pluralité de LEDs, indépendamment des variations de températures de jonction des LEDs et en réduisant significativement le risque de fausses détections positives. Il est usuel d'inclure des thermistors sur un circuit imprimé comprenant un assemblage de LEDs, afin de pouvoir détecter des températures très élevées susceptibles d'endommager les LEDs. De même, la tension aux bornes d'un tel montage est couramment mesurée et utilisée pour contrôler le dispositif de pilotage de l'alimentation du montage. La nouvelle fonctionnalité selon l'invention peut donc être réalisée sans composants et donc sans coûts ajoutés par rapport à des dispositifs lumineux connus, en utilisant les mesures mises à disposition d'une façon précédemment non connue. Comme le calibrage du dispositif se fait de manière automatique, il n'est pas nécessaire de calibrer le dispositif lors de sa production. L'apprentissage dynamique de la caractéristique V_{f}(T) au cours de la durée de vie du dispositif adapte le dispositif aux conditions dans lequel le véhicule automobile qu'il équipe évolue réellement, sans devoir prendre recours à des hypothèses de températures d'opération hypothétiques et potentiellement erronées.

D'autres caractéristiques et avantages de la présente invention seront mieux compris à l'aide de la description exemplaire et des dessins parmi lesquels :
- la figure 1 est une illustration schématique d'un mode de réalisation préféré du dispositif selon l'invention ;
- la figure 2 est une illustration schématique des moyens de traitement de la figure 1, illustrant également les principales étapes d'un mode de réalisation préféré du procédé selon l'invention.
Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif.

Divers composants nécessaires au fonctionnement d'un dispositif lumineux pour un véhicule automobile, qui n'ont néanmoins pas d'impact sur le fonctionnement de l'invention, ne seront pas décrits dans le contexte de l'invention et sont en soi connus dans l'art. Il s'agit par exemple de moyens de dissipation thermique, ou de moyens optiques tels que des lentilles ou de guides d'ondes.

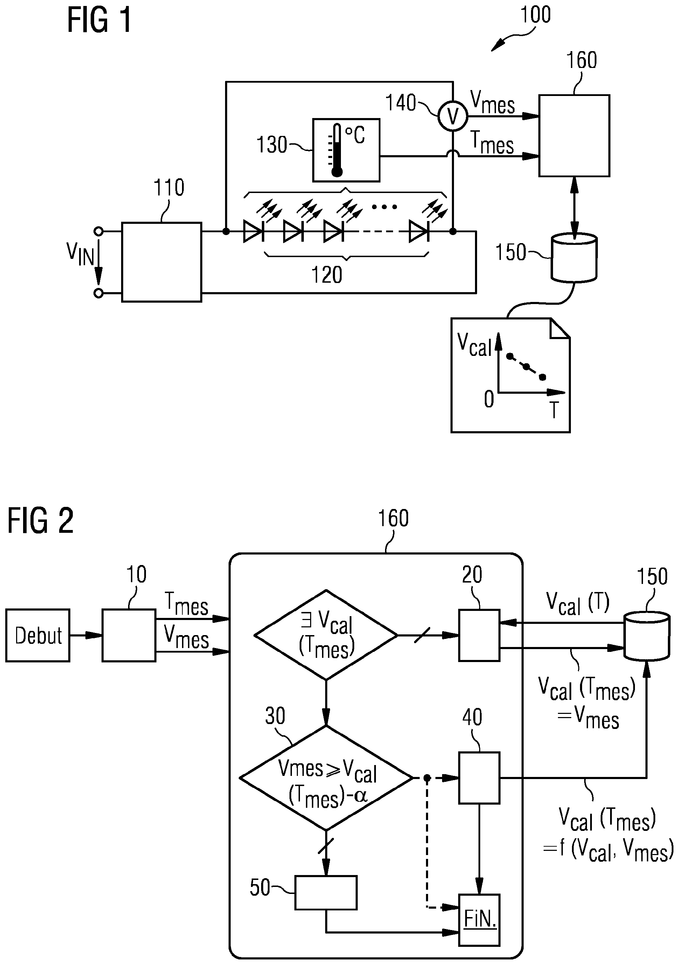

La figure 1 montre de manière schématique un mode de réalisation préféré du dispositif lumineux 100 selon l'invention. Une pluralité de diodes électroluminescentes, LEDs, est alimentée par le biais de moyens de pilotage de l'alimentation 110. De tels moyens 110 sont connus en soi dans l'art et engendrent au moins un convertisseur apte à convertir une tension continue d'entrée Vᵢₙ, fournie en général par une batterie du véhicule automobile, en une tension de charge d'une valeur différente et adaptée pour alimenter le montage 120.

Les LEDs qui réalisent ensemble au moins une fonction lumineuse du dispositif lumineux, sont montées en série et regroupées dans le montage 120. Le montage des LEDs se trouve en général sur un circuit imprimé, PCB (« printed circuit board »), dédié et déporté par rapport aux moyens 110. Le montage 120 peut également être disposé sur un dispositif d'interconnexion moulé, MID (« molded interconnect device »), à géométrie plus complexe. Les moyens 110 peuvent par exemple comprendre un élément microcontrôleur apte à contrôler la tension de charge en fonction de la fonction lumineuse requise.

Le dispositif comprend des premiers moyens de mesure 130, aptes à fournir un signal indicatif de la température de jonction des LEDs. Il s'agit par exemple d'un thermistor monté sur la carte imprimée qui supporte le montage 120. La température de la carte imprimée peut de manière réaliste être assimilée à la température de jonction d'une LED montée sur la carte imprimée. Comme la résistance d'un thermistor décroit selon un profil prédéterminé lorsque sa température augmente, un signal indicatif la température de la carte imprimée, et donc de la jonction semiconductrice des LEDs, peut être obtenu en mesurant la tension électrique aux bornes du thermistor. De tels circuits de mesure sont en soi connus dans l'art et ne seront pas décrits dans plus de détails dans le cadre de la présente invention. D'autres moyens de mesure de la température du circuit imprimé et/ou de la température de jonction des LEDs peuvent être implémentés par l'homme du métier sans pour autant sortir du cadre de l'invention.

Le dispositif comprend également des deuxièmes moyens de mesure 140 aptes à fournir un signal indicatif de la tension électrique aux bornes du montage. Les premiers et deuxièmes moyens de mesure 130, 140 fournissent les mesures en temps réel à des moyens de traitement 160. Les moyens de traitement peuvent par exemple comprendre un élément microprocesseur programmable ou un élément microcontrôleur. Avantageusement, il peut s'agir d'un élément microcontrôleur des moyens de pilotage 110 de l'alimentation du montage 120. Les moyens de traitement 160 ont accès en écriture et en lecture sur un élément de mémoire non volatile 150. De tels éléments de mémoire sont bien connus dans l'art et peuvent être intégrés aux moyens de traitement 160.

Les moyens de traitement 160 comprennent, également dans un élément de mémoire non volatile, des instructions qui, lorsqu'elles sont exécutées, amènent les moyens 160 à réaliser différentes étapes selon le procédé inventif. En utilisant en entrée une mesure de température Tₘₑₛ et une valeur de tension Vₘₑₛ fournies par les moyens de mesure 130 et 140 respectivement, les moyens de traitement sont aptes à détecter si une des LEDs du montage 120 est court-circuitée ou non. En même temps, les moyens de traitement construisent par apprentissage consécutif d'une série de mesures un profil dans l'élément de mémoire 150. Le profil qui met en relation les tensions mesurées avec les températures auxquelles elles ont étés mesurées. Ce profil sert de référence lors de la détection d'un court-circuit. En effet, lorsque les N LEDs du montage 120 fonctionnent, la tension mesurée aux bornes du montage est égal à Vₘₑₛ=N·V_{f}(Tₘₑₛ). Evidemment, un tel profil correspond à une fonction lumineuse spécifique. Si les LEDs du montage 120 peuvent réaliser plusieurs fonctions lumineuses à des intensités de courant appliquées différentes, le mode de fonctionnement spécifique définit le profil à utiliser lors du procédé. Ainsi, l'élément de mémoire 150 peut comprendre une pluralité de profils dans certains modes de réalisation. Comme les moyens de traitement 160 sont de préférence intégrés aux moyens de pilotage 110 qui déterminent la tension appliquée aux LEDs, l'information nécessaire au bon choix du profil est disponible.

Dans ce qui suit, le procédé selon l'invention et le fonctionnement des moyens de traitement 160 sera décrit en détail. Les moyens de traitement sont configurés pour comparer la tension électrique aux bornes du montage des LEDs, mesurée à un premier instant donné, à la tension électrique aux bornes du montage mesurée à un deuxième instant donné, la comparaison étant conditionnée à l'identité de la température de jonction des LEDs mesurée audits premier et deuxième instants. En outre les moyens de traitement sont configurés pour détecter une défaillance d'au moins une des LEDs du montage en fonction de cette comparaison.

La figure 2 illustre les étapes principales du procédé selon l'invention dans un mode de réalisation préféré. Lors d'une première étape 10, les valeurs Tₘₑₛ et Vₘₑₛ sont obtenues par les moyens de traitement 160. L'élément de mémoire 150 est consulté afin d'établir si une valeur de tension a déjà été associée à la température mesurée. Si c'est le cas, la valeur de tension V_{cal} ainsi trouvée est utilisée comme valeur de référence à laquelle la valeur mesurée Vₘₑₛ est comparée lors de l'étape 30.

La valeur V_{cal} représente la tension directe cumulée des N LEDs, N·V_{f}(Tₘₑₛ), à la température Tₘₑₛ. Il s'ensuit que, lorsque la tension mesurée Vₘₑₛ est inférieure à (Vₘₑₛ+/- a), le procédé peut conclure qu'une des LEDs du montage est court-circuitée. Ceci correspond à l'étape 50.

Le paramètre α définit une valeur seuil pour la détection d'un court-circuit. En pratique on utilise une valeur α comprise entre 0 et la valeur minimale que la tension directe d'une des LEDs du montage peut prendre. Si V_{fmin} est la tension directe d'une LED à 90°C, alors on peut par exemple fixer α=0,8·V_{fmin}.

De manière alternative, le procédé peut enregistrer directement les valeurs ajustées V_{cal}-α dans l'élément de mémoire 150, ce qui permet la comparaison directe entre la valeur de tension Vₘₑₛ et la valeur de tension de référence enregistrée et associée à la température Tₘₑₛ.

Avantageusement, les moyens de traitement sont configurés à émettre un signal d'alerte et à notifier celui-ci à l'utilisateur du véhicule lorsqu'un court-circuit est détecté. Des moyens d'alerte ne sont pas illustrés sur les figures et sont en soi connus dans l'état de l'art.

Si l'élément de mémoire 150 ne comprend pas de valeur de tension associée à la température mesurée Tₘₑₛ, identique à la température mesurée, une nouvelle valeur V_{cal}(Tₘₑₛ) = Vₘₑₛ est écrite et enregistré dans l'élément de mémoire 150 et vient ainsi compléter le profil enregistré.

Lorsqu'à l'issue de l'étape de comparaison 30 il s'avère que la tension mesurée Vₘₑₛ est supérieure ou égale à la valeur seuil (Vₘₑₛ+/-α) correspondante, le procédé conclut que toutes les LEDs fonctionnent correctement, et qu'aucune des LEDs n'est court-circuitée. De manière optionnelle, la valeur mesurée peut être utilisée pour raffiner ou mettre à jour la valeur de tension V_{cal}(Tₘₑₛ) dans l'élément de mémoire 150. Par exemple, une moyenne pondérée de la valeur de tension préalablement associée à la température Tₘₑₛ et de la valeur de tension mesurée peut remplacer la valeur de tension préalablement associée à cette température.

Dans tous les modes de réalisation du procédé selon l'invention, plusieurs étapes supplémentaires décrites dans ce qui suit peuvent être considérées. Afin d'éviter l'utilisation de mesures erronées, les valeurs obtenues à l'étape 10 peuvent être vérifiées ou filtrées avant de les utiliser aux étapes suivantes. Par exemple, lors d'une étape de filtrage, des mesures n'appartenant pas à une plage prédéterminée sont écartées. La plage de mesure prédéterminée pour la mesure Tₘₑₛ comprend par exemple les valeurs entre -40°C et 90°C. La plage de mesures prédéterminée pour la mesure Vₘₑₛ comprend par exemple les valeurs entre 0 Volt et N·V_{fmax} Volt, N étant le nombre de LEDs du montage et V_{fmax} étant la tension directe d'une des LEDs du montage à -40°C.

Le procédé est de préférence répété de manière périodique. Ceci permet d'une part d'assurer le contrôle régulier du bon fonctionnement des LEDs, et d'autre part l'apprentissage de nouvelles valeurs et la mise à jour régulière du profil enregistré dans l'élément de mémoire. Afin d'obtenir des valeurs représentatives, il est important de s'assurer que la température et la tension mesurées sont dans un régime stable lors des prises de mesures. Suite à des variations importantes de température ou de tension, un régime stable est en pratique obtenu au bout de quelques secondes. C'est pourquoi le procédé est de préférence répété de manière périodique toutes les 2 à 30 secondes. Il peut également être répété de manière périodique à l'échéance de plusieurs minutes. Alternativement, le dispositif selon l'invention comprend des moyens de détection aptes à identifier si les valeurs mesurées par les moyens de mesure 130 et 140 sont dans un régime stable. Le procédé peut alors être mis en oeuvre uniquement si un régime stable est déterminé. Par régime stable on entend le maintien des mesures à des valeurs généralement constantes pendant un laps de temps prédéfinis de 1 à 10 secondes.

Dans un mode de réalisation du procédé selon l'invention, lors de l'étape d'enregistrement 20 de la valeur de tension mesurée Vₘₑₛ, celle-ci est remplacée par une moyenne pondérée de la valeur Vₘₑₛ et d'au moins une valeur de tension associée dans l'élément de mémoire 150 à une température voisine comprise dans la plage [Tₘₑₛ-β, Tₘₑₛ+β], β étant compris entre 0,1 et 10 °C. Ceci permet d'interpoler des valeurs intermédiaires.

Dans tous les modes de réalisation, le procédé peut comprendre une étape préalable de mise à disposition de valeurs de tension initiales associées à une pluralité de valeurs de températures dans l'élément de mémoire 150. Ce profil initial est alors mis à jour par les étapes du procédé au cours de la durée de vie du dispositif.

## Revendications

1. Dispositif lumineux (100) pour un véhicule automobile, le dispositif comprenant
- des moyens de pilotage (110) de l'alimentation d'une pluralité de diodes électroluminescentes, LED, montées en série (120), chacune des LEDs ayant la même tension directe, V_{f}, dépendante de sa température de jonction ;
- des premiers moyens de mesure (130) de la température de jonction des LEDs (120) ;
- des deuxièmes moyens de mesure (140) de la tension électrique aux bornes du montage ;
- un élément de mémoire (150),
- des moyens de traitement (160) pour détecter une défaillance d'au moins une des LEDs du montage, et pour lire et écrire dans ledit élément de mémoire (150),
**caractérisé en ce que** les moyens de traitement (160) sont configurés pour répéter de manière périodique :
- obtenir (10) à l'aide des moyens de mesure (130, 140) une mesure, Tₘₑₛ, indicative de la température de jonction d'au moins une des LEDs et une mesure, Vₘₑₛ, indicative de la tension électrique aux bornes du montage (120) à un instant donné lorsque le montage (120) est alimenté,
- si l'élément de mémoire (150) ne comprend pas de valeur de tension, V_{cal}, associée à la mesure Tₘₑₛ, enregistrer (20) la mesure Vₘₑₛ et l'associer à la mesure Tₘₑₛ dans l'élément de mémoire (150), la valeur de tension V_{cal} représentant la tension directe cumulée des LEDs à la température Tₘₑₛ,
- si l'élément de mémoire (150) comprend une valeur de tension, V_{cal}, associée à la température Tₘₑₛ, comparer (30) la mesure Vₘₑₛ à V_{cal} ou à une tension de comparaison dépendant directement de V_{cal} ;
- conclure (50) qu'une des LEDs du montage (120) est court-circuitée en fonction de ladite comparaison.

2. Dispositif lumineux selon la revendication précédente, dans lequel les moyens de traitement sont configurés pour :
- si l'élément de mémoire (150) comprend une valeur de tension V_{cal} associée à la température Tₘₑₛ, comparer (30) la mesure Vₘₑₛ à (V_{cal}+/-α), 0 < a ≤V_{f}
- conclure (50) qu'une des LEDs du montage (120) est court-circuitée si Vₘₑₛ<V_{cal}+/- a).

3. Dispositif selon l'une des revendications précédentes, dans lequel les moyens de traitement sont en outre configurés à mettre à jour (40) la valeur de tension V_{cal} enregistrée en utilisant la valeur Vₘₑₛ, si Vₘₑₛ ≥ (V_{cal}+/-α).

4. Procédé de détection d'une diode électroluminescente, LED, court-circuitée dans un dispositif lumineux (100) pour un véhicule automobile, le dispositif comprenant
- des moyens de pilotage (110) de l'alimentation d'une pluralité de diodes électroluminescentes, LED, montées en série (120), chacune des LEDs ayant la même tension directe, V_{f}, dépendante de sa température de jonction ;
- des premiers moyens de mesure (130) de la température de jonction des LEDs (120) ;
- des deuxièmes moyens de mesure (140) de la tension électrique aux bornes du montage ;
- un élément de mémoire (150),
- des moyens de traitement (160) pour détecter une défaillance d'au moins une des LEDs du montage, et pour lire et écrire dans ledit élément de mémoire (150),
**caractérisé en ce que** le procédé comprend répéter de manière périodique les étapes suivantes :
- obtenir (10) à l'aide des moyens de mesure (130, 140) une mesure, Tₘₑₛ, indicative de la température de jonction d'au moins une des LEDs et une mesure, Vₘₑₛ, indicative de la tension électrique aux bornes du montage (120) à un instant donné lorsque le montage (120) est alimenté,
- si un élément de mémoire (150) ne comprend pas de valeur de tension associée, V_{cal}, à la mesure Tₘₑₛ, enregistrer (20) la mesure Vₘₑₛ et l'associer à la mesure Tₘₑₛ dans l'élément de mémoire (150), la valeur de tension V_{cal} représentant la tension directe cumulée des LEDs à la température Tₘₑₛ,
- si l'élément de mémoire (150) du dispositif lumineux comprend une valeur de tension, V_{cal}, associée à la température Tₘₑₛ, comparer (30) la mesure Vₘₑₛ à V_{cal} ou à une tension de comparaison dépendant directement de V_{cal};
- conclure (50) qu'une des LEDs du montage (120) est court-circuitée en fonction de ladite comparaison.

5. Procédé selon la revendication précédente, dans lequel le procédé comprend les étapes suivantes :
- si l'élément de mémoire (150) comprend une valeur de tension V_{cal} associée à la température Tₘₑₛ, comparer (30) la mesure Vₘₑₛ à (V_{cal}+/-α), 0 < a ≤V_{f} ;
- conclure (50) qu'une des LEDs du montage (120) est court-circuitée si Vₘₑₛ<V_{cal}+/-α).

6. Procédé selon une des revendications 4 et 5, dans lequel le procédé comprend en outre l'étape de mettre à jour (40) la valeur de tension V_{cal} enregistrée et associée à la mesure Tₘₑₛ en utilisant la valeur Vₘₑₛ, si Vₘₑₛ ≥ (V_{cal}+/-α) ;

7. Procédé selon une des revendications 4 à 6, dans lequel le procédé comprend une étape intermédiaire de filtrage des mesures suite à l'étape d'obtention (10), lors de laquelle des mesures n'appartenant pas à une plage prédéterminée sont écartées.

8. Procédé selon une des revendications 4 à 7, dans lequel les étapes obtenir (10), enregistrer (20), comparer (30) et conclure (50) sont mises en œuvre si la température de jonction des LEDs et la tension électrique aux bornes du montage ont des valeurs généralement constantes.

9. Procédé selon une des revendications 4 à 8, dans lequel le procédé comprend une étape préalable de mise à disposition de valeurs de tension initiales associées à une pluralité de valeurs de températures dans l'élément de mémoire (150).

## Patentansprüche

1. Beleuchtungsvorrichtung (100) für ein Kraftfahrzeug, wobei die Vorrichtung umfasst
- Mittel (110) zur Steuerung (110) der Stromversorgung einer Vielzahl von in Reihe (120) geschalteten Leuchtdioden, LEDs, wobei jede der LEDs die gleiche Vorwärtsspannung Vf ᵢₙ Abhängigkeit von ihrer Sperrschichttemperatur hat;
- erste Mittel (130) zur Messung der Sperrschichttemperatur der LEDs (120) ;
- zweite Mittel (140) zur Messung der elektrischen Spannung an den Anschlüssen der Baugruppe;
- ein Speicherelement (150),
- Verarbeitungsmittel (160) zum Erkennen eines Ausfalls von mindestens einer der LEDs der Baugruppe und zum Lesen und Schreiben von dem Speicherelement (150),
**dadurch gekennzeichnet, dass** das Verarbeitungsmittel (160) so konfiguriert ist, dass es sich periodisch wiederholt:
- Erhalten (10) einer Messung, Tmes, die die Sperrschichttemperatur von mindestens einer der LEDs anzeigt, und einer Messung, Vmes, die die elektrische Spannung an der Vorrichtung (120) zu einem gegebenen Zeitpunkt anzeigt, wenn die Vorrichtung (120) mit Strom versorgt wird, unter Verwendung der Messmittel (130, 140),
- wenn das Speicherelement (150) keinen dem Messwert Tmes zugeordneten Spannungswert Vcal enthält, Speichern (20) des Messwerts Vmes und Zuordnen desselben zu dem Messwert Tmes in dem Speicherelement (150), wobei der Spannungswert Vcal die kumulative Vorwärtsspannung der LEDs bei der Temperatur Tmes darstellt,
- wenn das Speicherelement (150) einen der Temperatur Tmes zugeordneten Spannungswert Vcal aufweist, Vergleich (30) der Messung Vmes mit Vcal oder mit einer direkt von Vcal abhängigen Vergleichsspannung;
- zu dem Schluss (50), dass eine der LEDs in der Anordnung (120) entsprechend dem genannten Vergleich kurzgeschlossen ist.

2. Beleuchtungsvorrichtung nach dem vorhergehenden Anspruch, wobei die Verarbeitungsmittel so konfiguriert sind, dass :
- wenn das Speicherelement (150) einen der Temperatur Tmes zugeordneten Spannungswert Vcal enthält, vergleichen Sie (30) die Messung Vmes mit (Vcal+/-a), 0 < α ≤Vf
- schließen (50), dass eine der LEDs der Baugruppe (120) kurzgeschlossen ist, wenn Vmes<(Vcal+/-α).

3. Beleuchtungsvorrichtung gemäß einem der vorhergehenden Ansprüche, wobei die Verarbeitungsmittel ferner so konfiguriert sind, dass sie den gespeicherten Spannungswert Vcal unter Verwendung des Wertes Vmes aktualisieren (40), wenn Vmes ≥ (Vcal+/-α).

4. Verfahren zum Erfassen einer kurzgeschlossenen Leuchtdiode, LED, in einer Beleuchtungsvorrichtung (100) für ein Kraftfahrzeug, wobei die Vorrichtung umfasst
- Mittel (110) zur Steuerung (110) der Stromversorgung einer Vielzahl von in Reihe (120) geschalteten Leuchtdioden, LEDs, wobei jede der LEDs die gleiche Vorwärtsspannung, Vf, in Abhängigkeit von ihrer Sperrschichttemperatur hat;
- erste Mittel (130) zur Messung der Sperrschichttemperatur der LEDs (120) ;
- zweite Mittel (140) zur Messung der elektrischen Spannung an den Anschlüssen der Baugruppe;
- ein Speicherelement (150),
- Verarbeitungsmittel (160) zum Erkennen eines Ausfalls von mindestens einer der LEDs der Baugruppe und zum Lesen und Schreiben von dem Speicherelement (150),
**dadurch gekennzeichnet, dass** das Verfahren die folgenden, periodisch wiederholten Schritte umfasst:
- Erhalten (10) einer Messung, Tmes, die die Sperrschichttemperatur von mindestens einer der LEDs anzeigt, und einer Messung, Vmes, die die elektrische Spannung an der Vorrichtung (120) zu einem gegebenen Zeitpunkt anzeigt, wenn die Vorrichtung (120) mit Strom versorgt wird, unter Verwendung der Messmittel (130, 140),
- wenn ein Speicherelement (150) keinen dem Messwert Tmes zugeordneten Spannungswert Vcal enthält, Speichern (20) des Messwerts Vmes und Zuordnen desselben zu dem Messwert Tmes in dem Speicherelement (150), wobei der Spannungswert Vcal die kumulative Vorwärtsspannung der LEDs bei der Temperatur Tmes darstellt,
- wenn das Speicherelement (150) der Leuchtvorrichtung einen Spannungswert Vcal aufweist, der der Temperatur Tmes zugeordnet ist, Vergleichen (30) der Messung Vmes mit Vcal oder mit einer direkt von Vcal abhängigen Vergleichsspannung;
- zu dem Schluss (50), dass eine der LEDs in der Anordnung (120) entsprechend dem genannten Vergleich kurzgeschlossen ist.

5. Verfahren nach dem vorhergehenden Anspruch, wobei das Verfahren die folgenden Schritte umfasst:
- wenn das Speicherelement (150) einen der Temperatur Tmes zugeordneten Spannungswert Vcal enthält, vergleichen (30) Sie den Messwert Vmes mit (Vcal+/- α), 0 < α ≤Vf ;
- schließen (50), dass eine der LEDs der Baugruppe (120) kurzgeschlossen ist, wenn Vmes<(Vcal+/-α).

6. Verfahren nach einem der Ansprüche 4 und 5, wobei das Verfahren ferner den Schritt des Aktualisierens (40) des aufgezeichneten Spannungswertes Vcal, der mit der Messung Tmes verbunden ist, unter Verwendung des Wertes Vmes, wenn Vmes ≥ (Vcal+/-a) ;

7. Verfahren nach einem der Ansprüche 4 bis 6, wobei das Verfahren einen Zwischenschritt des Filterns der Messungen im Anschluss an den Gewinnungsschritt (10) umfasst, bei dem Messungen, die nicht zu einem vorbestimmten Bereich gehören, verworfen werden.

8. Verfahren nach einem der Ansprüche 4 bis 7, bei dem die Schritte Erhalten (10), Aufzeichnen (20), Vergleichen (30) und Abschließen (50) durchgeführt werden, wenn die Sperrschichttemperatur der LEDs und die Spannung über der Schaltung allgemein konstante Werte haben.

9. Verfahren nach einem der Ansprüche 4 bis 8, wobei das Verfahren einen vorherigen Schritt der Bereitstellung von Anfangsspannungswerten umfasst, die mit einer Vielzahl von Temperaturwerten im Speicherelement (150) verbunden sind.

## Claims

1. A lighting device (100) for a motor vehicle, the device comprising
- means (110) for controlling (110) the power supply of a plurality of light-emitting diodes, LEDs, connected in series (120), each of the LEDs having the same forward voltage, Vf, depending on its junction temperature ;
- first means (130) for measuring the junction temperature of the LEDs (120) ;
- second means (140) for measuring the electrical voltage across the terminals of the assembly;
- a memory element (150),
- processing means (160) for detecting a failure of at least one of the LEDs of the assembly, and for reading from and writing to said memory element (150),
**characterised in that** the processing means (160) is configured to repeat periodically:
- obtaining (10) using the measuring means (130, 140) a measurement, Tₘₑₛ, indicative of the junction temperature of at least one of the LEDs and a measurement, Vₘₑₛ, indicative of the electrical voltage across the fixture (120) at a given time when the fixture (120) is powered,
- if the memory element (150) does not include a voltage value, V_{cal}, associated with the measurement Tₘₑₛ, storing (20) the measurement Vₘₑₛ and associating it with the measurement Tₘₑₛ in the memory element (150), the voltage value V_{cal} representing the cumulative forward voltage of the LEDs at the temperature Tₘₑₛ,
- if the memory element (150) comprises a voltage value, V_{cal}, associated with the temperature Tₘₑₛ, comparing (30) the measurement Vₘₑₛ with V_{cal} or with a comparison voltage directly dependent on V_{cal};
- conclude (50) that one of the LEDs in the arrangement (120) is short-circuited in accordance with said comparison.

2. Lighting device according to the preceding claim, wherein the processing means are configured to :
- if the memory element (150) includes a voltage value V_{cal} associated with the temperature Tₘₑₛ, compare (30) the measurement Vₘₑₛ to (V_{cal}+/-α), 0 < a ≤Vf
- conclude (50) that one of the LEDs of the assembly (120) is short-circuited if Vₘₑₛ<(_{Vcal+}/-α).

3. Lighting device according to one of the preceding claims, wherein the processing means are further configured to update (40) the stored voltage value V_{cal} using the value Vₘₑₛ, if Vₘₑₛ ≥ (V_{cal}+/-α).

4. A method of detecting a short-circuited light-emitting diode, LED, in a lighting device (100) for a motor vehicle, the device comprising
- means (110) for controlling (110) the power supply of a plurality of light-emitting diodes, LEDs, connected in series (120), each of the LEDs having the same forward voltage, V_{f}, dependent on its junction temperature ;
- first means (130) for measuring the junction temperature of the LEDs (120) ;
- second means (140) for measuring the electrical voltage across the terminals of the assembly;
- a memory element (150),
- processing means (160) for detecting a failure of at least one of the LEDs of the assembly, and for reading from and writing to said memory element (150),
**characterized in that** the method comprises the following steps periodically repeated:
- obtaining (10) using the measuring means (130, 140) a measurement, Tmes, indicative of the junction temperature of at least one of the LEDs and a measurement, Vₘₑₛ, indicative of the electrical voltage across the fixture (120) at a given time when the fixture (120) is powered,
- if a memory element (150) does not include a voltage value, V_{cal}, associated with the measurement Tₘₑₛ, storing (20) the measurement Vₘₑₛ and associating it with the measurement Tₘₑₛ in the memory element (150), the voltage value V_{cal} representing the cumulative forward voltage of the LEDs at the temperature Tₘₑₛ,
- if the memory element (150) of the luminous device comprises a voltage value, V_{cal}, associated with the temperature Tₘₑₛ, comparing (30) the measurement Vₘₑₛ with V_{cal} or with a comparison voltage directly dependent on V_{cal};
- conclude (50) that one of the LEDs in the arrangement (120) is short-circuited in accordance with said comparison.

5. Method according to the preceding claim, wherein the method comprises the following steps:
- if the memory element (150) includes a voltage value V_{cal} associated with the temperature Tₘₑₛ, compare (30) the measurement Vₘₑₛ to (V_{cal}+/-α), 0 < α ≤Vf ;
- conclude (50) that one of the LEDs of the assembly (120) is short-circuited if Vₘₑₛ<(V_{cal}+/-α).

6. Method according to one of claims 4 and 5, wherein the method further comprises the step of updating (40) the recorded voltage value V_{cal} associated with the measurement Tmes using the value Vₘₑₛ, if Vₘₑₛ ≥ (V_{cal}+/-α) ;

7. Method according to one of claims 4 to 6, wherein the method comprises an intermediate step of filtering the measurements following the obtaining step (10), in which measurements not belonging to a predetermined range are discarded.

8. Method according to one of claims 4 to 7, in which the steps obtain (10), record (20), compare (30) and conclude (50) are performed if the junction temperature of the LEDs and the voltage across the circuit have generally constant values.

9. Method according to one of claims 4 to 8, wherein the method comprises a prior step of providing initial voltage values associated with a plurality of temperature values in the memory element (150).
